# FASCICULE DE BREVET EUROPEEN

(11) **EP 2 608 252 B1**
(45) Date de publication et mention de la délivrance du brevet: **18.04.2018**
(21) Numéro de dépôt: 12195967.0
(22) Date de dépôt: 06.12.2012
(51) Int. Cl.: H01L 21/762, B32B 3/02, B32B 38/10, B32B 7/02

(54) **Méthode de fabrication d'une structure souple par transfert de couches et stucture correspondante**
Verfahren zur Herstellung einer flexiblen Struktur durch Schichtentransfer und entsprechende Struktur
Method of manufacturing a flexible structure by layer transfer and corresponding structure

(30) Priorité: 20.12.2011 FR 1162086
(43) Date de publication de la demande: 26.06.2013
(73) Titulaire: COMMISSARIAT À L'ÉNERGIE ATOMIQUE ET AUX ÉNERGIES ALTERNATIVES, 75015 Paris (FR)
(72) Inventeur: Moriceau, Hubert, 38120 Saint-Egreve (FR); Argoud, Maxime, 69003 Lyon (FR); Fournel, Frank, 38190 Villard-Bonnot (FR); Morales, Christophe, 38220 St Pierre de Mesage (FR); Mazen, Frédéric, 38100 Grenoble (FR)
(74) Mandataire: Delorme, Nicolas

(56) Documents cités:
- EP-A1- 1 798 764
- EP-A1- 2 157 602
- FR-A1- 2 961 515
- US-A1- 2003 036 247

## Description

La présente invention concerne un procédé de fabrication d'une structure souple adaptée à la préhension, notamment pour appliquer au moins une étape de micro-technologie, de microélectronique ou de nettoyage.

L'invention concerne également une structure intermédiaire et une structure souple. Le procédé de fabrication et la structure souple peuvent notamment trouver une application dans le domaine des technologies souples, de la micro-technologie, de la microélectronique, de l'électronique flexible comme les cartes à puce, des textiles intelligents et notamment pour la fabrication de jauges de contrainte.

Le domaine des technologies souples nécessite de former des dispositifs électroniques sur ou dans des films minces constitués d'un matériau monocristallin élastiquement déformables, d'une épaisseur inférieure par exemple à 5 micromètres. Or, des films souples d'un matériau monocristallin sont peu disponibles en tant que tels et les films souples, s'ils existent ou s'ils sont réalisés sans support, sont trop minces pour pouvoir être manipulés aisément, notamment par des moyens standard de la microélectronique. Les films ont en effet tendance à s'enrouler sur eux-mêmes, à se déformer ou à se plisser, ce qui rend difficile leur utilisation dans la fabrication de dispositifs électroniques.

Le document US 2003/0036247 décrit un procédé de production d'une structure semiconductrice par double implantation de part et d'autre d'un substrat. La structure semiconductrice obtenue comprend une plaquette de base, qui peut être une plaquette de Si, une couche d'oxyde isolante, qui peut être constituée de SiO2 et placée de façon adjacente à la plaquette de base, et une couche supérieure active de SiC allogène. La croissance de films minces de matériau monocristallin sur des substrats souples existants, tels que les polymères ou les feuilles métalliques, est impossible car ces substrats ne présentent pas une surface germe adaptée à la croissance d'un matériau monocristallin de la qualité souhaitée.

Par ailleurs, le transfert de film très mince sur des substrats souples par la technologie Smart Cut™ utilisant un substrat source fragilisé est difficile à obtenir. Parfois, une partie seulement du film est transféré. Ceci s'explique car le substrat souple n'apporte pas la raideur nécessaire pour le développement selon un plan ou région de fragilisation des cavités formées par implantation dans le substrat source. Les cavités se développent alors dans toutes les directions et en particulier suivant un axe perpendiculaire au plan ou région de fragilisation, ce qui peut provoquer le cloquage du film.

Il est par contre possible de transférer un film mince d'un substrat source en matériau monocristallin sur un substrat souple, tel qu'un polymère, en intercalant un film raidisseur entre le film mince et le substrat souple. Si la structure obtenue est effectivement souple, elle est difficilement utilisable ultérieurement dans des procédés technologiques. La structure présente en général une forte déformation (en flexion ou torsion...) à température ambiante du fait des contraintes emmagasinées dans les différents films au cours de la fabrication de la structure.

Un des buts de l'invention est de pallier cet inconvénient, et de proposer une structure souple manipulable, comportant un film mince en matériau monocristallin et dont la flèche spontanée (c'est-à-dire en l'absence de sollicitation extérieure et à température ambiante) est faible, de sorte à pouvoir réaliser des étapes de micro-technologies ou micro-électroniques dans ou en surface du film mince.

A cet effet et selon un premier aspect, l'invention a pour objet un procédé de fabrication d'une structure souple, caractérisé en ce que le procédé comprend les étapes suivantes :
- implanter des espèces ioniques dans un premier substrat source, de sorte à former une première région de fragilisation délimitant un premier film mince, notamment constitué d'un matériau monocristallin,
- implanter des espèces ioniques dans un deuxième substrat source, de sorte à former une deuxième région de fragilisation délimitant un deuxième film mince, notamment constitué d'un matériau monocristallin,
- fournir un substrat souple dont la rigidité R est inférieure ou égale à 10⁷ GPa.µm³,
- solidariser les premier et deuxième films minces respectivement à la première face et à la deuxième face du substrat souple de sorte à former un empilement comportant la structure souple délimitée par les première et deuxième régions de fragilisation, la structure souple présentant un effet raidisseur adapté pour permettre les transferts des premier et deuxième films minces, et
- appliquer un budget thermique de fracture pour transférer les premier et deuxième films minces sur le substrat souple.

Le procédé permet ainsi l'obtention d'une structure souple présentant un rayon de courbure spontané supérieur à 20 cm, de préférence supérieur à 50 cm, et de préférence encore supérieur à 1m.

Cette structure, si elle présente par ailleurs des dimensions suffisantes (typiquement supérieur à quelques millimètres), est facilement manipulable. C'est le cas avec des dimensions standard de substrats, par exemple 100 ou 200 mm de diamètre. Cette structure est adaptée à la préhension, il est notamment possible de lui appliquer au moins une étape de micro-technologie, de microélectronique ou de nettoyage.

La rigidité R peut être calculée par l'application de la formule R= EH³/12(1-ν²). E représente la valeur du module d'Young du matériau du substrat souple (en GPa), H correspond à la hauteur ou à l'épaisseur du substrat (en micromètre) et ν(nu) correspond au coefficient de Poisson du matériau (sans unité). La rigidité ou rigidité en flexion du substrat souple est faible de sorte à permettre une déformation élastique assez importante par application d'une contrainte extérieure par exemple. Par comparaison, un substrat rigide de silicium présentant une épaisseur commerciale de 725 micromètres, dont le module d'Young est d'environ 130 GPa et pour lequel les capacités de déformation élastique sont très faibles, présente une rigidité de l'ordre de 4.10⁹ GPa.µm³.

Le 'rayon de courbure' ρ pour une structure cylindrique est obtenu par application de la formule r²/2Δ avec r présentant le rayon de cette structure et Δ (delta) la flèche prise par cette structure, mesurée au centre de la surface de cette structure. Par exemple, une flèche de 5 mm correspond à un rayon de courbure de 1 m pour une structure d'un rayon de 100 mm (ou 8 pouces).

L'expression 'rayon de courbure spontané' décrit le rayon de courbure intrinsèque à la structure souple lorsqu'elle n'est soumise à aucune contrainte extérieure et à température ambiante.

Par l'expression 'structure souple', on entend dans le présent document une structure déformable, conformable, qui peut être déformée élastiquement lors d'application de contraintes extérieures ultérieures, notamment apportées dans le cadre d'opération de micro-électronique ou de micro technologie ou au cours de son usage ultérieur, une fois les dispositifs formés. La souplesse de la structure lui garantit par exemple de pouvoir atteindre un rayon de courbure supérieur à 20cm, voire 50 cm et même 1 m, en préservant l'intégrité mécanique et fonctionnelle de la structure. Contrairement à une déformation plastique, la déformation élastique de la structure souple évite l'endommagement des matériaux des films minces, par exemple par formation de fissures ou de ruptures dans l'épaisseur du film, de striction, cloquage, arrachement ou délaminage du film mince transféré, de sorte que les matériaux conservent leurs propriétés au cours de la fabrication ou de l'utilisation.

Par ailleurs, il est à noter que la première face et la deuxième face du substrat souple auxquels sont solidarisés les premier et deuxième films minces sont des faces opposées du substrat souple.

Par l'expression 'solidariser les premier et deuxième films minces respectivement à la première face et à la deuxième face du substrat souple', on entend dans le présent document, l'action de solidariser la surface exposée des premier et deuxième films minces, c'est-à-dire les surfaces ayant subi l'implantation des espèces ioniques, respectivement à la première face et à la deuxième face du substrat souple.

Par l'expression 'effet raidisseur adapté pour permettre les transferts de films minces', on entend dans le présent document que l'effet raidisseur apporté par la rigidité du film mince, cumulé à celui apporté par la rigidité du substrat souple est suffisant pour le développement des cavités de la région fragilisée, parallèlement à la surface des substrats sources. Cet effet raidisseur permet notamment le transfert de films minces entiers sur un substrat souple, sans apparition de cloquage.

Par l'expression 'budget thermique', on entend dans le présent document l'application d'un traitement thermique sur une période de temps donnée.

Ainsi, il est possible de transférer des films minces sur un substrat souple de sorte à obtenir une structure souple et élastiquement déformable. Par ailleurs, la configuration sensiblement symétrique de la structure lui assure d'être manipulable, préhensible et surtout d'atteindre un rayon de courbure relativement élevé, c'est-à-dire d'obtenir une structure sensiblement plane en l'absence de sollicitation extérieure et sur laquelle il est alors possible de réaliser des étapes technologiques.

Selon un mode de réalisation, l'application du budget thermique de fracture est assistée par l'application de contraintes mécaniques telles que des contraintes en traction, cisaillement, flexion ou torsion, de sorte à compléter l'effet du budget thermique de fracture. Il est ainsi possible de diminuer la température ou la durée du budget thermique de fracture de sorte à ne pas endommager le substrat souple en polymère par exemple.

Selon une variante, avant l'étape de solidarisation, le procédé comprend les étapes consistant à
- former au moins un film raidisseur primaire sur le premier film mince et/ou sur la première face du substrat souple
- former au moins un film raidisseur secondaire sur le deuxième film mince et/ou sur la deuxième face du substrat souple, la rigidité cumulée des films raidisseurs primaire et secondaire étant inférieure ou égale à la rigidité R.

Par 'film raidisseur', on entend un film présentant une rigidité supérieure à celle du substrat souple pour une même épaisseur. Le film raidisseur est disposé de façon adjacente aux films minces. Ainsi, la structure souple comprend le substrat souple, les premier et deuxième films minces ainsi que les films raidisseurs primaire ou secondaire. Ces derniers complètent l'effet raidisseur apporté par les films minces et le substrat support de sorte à faciliter lors de l'application du budget thermique de fracture, la propagation de la fracture dans la région fragilisée, selon un plan sensiblement parallèle à la surface du substrat source. Les films minces, de même que le substrat souple participe dans une certaine mesure à cet effet raidisseur en fonction de leur rigidité propre et de leur épaisseur. Des films raidisseurs additionnels ne sont nécessaires que si les films minces et le substrat souple ne permettent pas à eux-seuls d'obtenir un effet raidisseur suffisant.

Les 'film raidisseur primaire' et 'film raidisseur secondaire', présentent des fonctions semblables. Dans certains modes de réalisation, ces films raidisseurs primaire et secondaire sont également semblables.

Il est ainsi possible de déposer un premier film raidisseur primaire sur un premier film mince et un deuxième film raidisseur primaire sur la première face du substrat souple de sorte à réaliser un collage direct entre les premier et deuxième films raidisseurs primaires. Le collage de ces premier et deuxième films raidisseurs conduit alors à former un unique film raidisseur primaire. Ce collage direct permet d'obtenir une grande énergie de collage favorable au transfert du film mince. Ces dépôts sont bien entendus également réalisables pour la solidarisation du deuxième film mince sur la deuxième face du substrat souple, indépendamment ou en complément de la solidarisation du premier film mince mettant en jeu les premier et deuxième films raidisseurs primaires.

Le film raidisseur peut être constitué de plusieurs couches de matériaux différents.

L'augmentation de rigidité de la structure liée à la présence des films raidisseurs primaire et secondaire doit être faible devant la rigidité du substrat souple de sorte à obtenir une structure de la souplesse désirée, avantageusement cette augmentation n'excède pas 50%, voire 20% de la rigidité du support souple.

De préférence, la formation des premier et deuxième films raidisseurs est effectuée par dépôt.

Selon un mode de réalisation, le procédé comprend les étapes de
- former le film raidisseur primaire sur le premier film mince
- former le film raidisseur secondaire sur le deuxième film mince,
et en ce que l'étape de solidarisation comprend les étapes de
- former une première couche d'un matériau adhésif, entre le film raidisseur primaire la première face du substrat souple, et
- former une deuxième couche d'un matériau adhésif entre le film raidisseur secondaire et la deuxième face du substrat souple, le matériau adhésif est notamment choisi parmi le DVD-bis-BCB, les polyimides et les polymères photosensibles de sorte à obtenir un collage adhésif entre les films raidisseurs et le substrat souple. Ce collage adhésif est simple à mettre en oeuvre. Il n'est pas nécessaire notamment de planariser et de nettoyer les surfaces avec beaucoup de précision avant de déposer la couche d'un matériau adhésif.

De préférence, le budget thermique de fracture est apporté par l'application d'une thermo-compression qui permet l'obtention du collage adhésif. La pression appliquée peut se situer aux alentours de 10kPa.

Selon une possibilité, les couches d'un matériau adhésif sont réticulées par un traitement thermique préliminaire, réalisé avant la mise en contact des films entre eux ou des films avec le substrat souple. Une fois mis en contact, l'énergie de collage obtenue peut alors être assez faible. Ceci est favorable à un démontage éventuel de la structure au niveau des première ou deuxième couches d'un matériau adhésif. Ce démontage peut être utile notamment après fabrication des dispositifs souhaités sur les films minces.

Selon une autre possibilité, les couches d'un matériau adhésif sont réticulées pendant l'application du budget thermique de fracture. L'énergie de collage obtenue est ainsi plus forte. Cette énergie de collage plus importante permet également d'appliquer des opérations technologiques qui génèrent des contraintes importantes dans la structure souple.

Alternativement, le procédé comprend les étapes de
- former le film raidisseur primaire sur la première face du substrat souple,
- former le film raidisseur secondaire sur la deuxième face du substrat souple,
et l'étape de solidarisation comprend un collage direct entre le film raidisseur primaire et le premier film mince et un collage direct entre le film raidisseur secondaire et le deuxième film mince.

Selon un mode de réalisation, les premiers et deuxièmes substrats sources sont constitués du même matériau et les étapes d'implantation sont réalisées dans les mêmes conditions (espèces, doses, énergie,...), le transfert des premier et deuxième films minces pourra alors avoir lieu simultanément, ou de façon décalée dans le temps, lors de l'application du budget de fracture.

Selon un autre mode de réalisation, les étapes d'implantation d'espèces ioniques dans les premier et deuxième substrats sources comprennent une étape d'implantation de doses différentes d'espèces ioniques dans les premier et deuxième substrats sources. Or, le budget thermique de fracture à appliquer pour l'obtention de la fracture du substrat source dépend notamment de la dose d'espèces ioniques implantées. Ainsi, lorsque les doses implantées dans les deux substrats sources sont différentes, les fractures respectives sont obtenues avec des traitements thermiques de fracture différents en terme de durée et/ou de température, notamment lorsque les matériaux implantés sont de nature identique. Lors de l'utilisation de substrats sources de matériaux différents, implantés avec des doses différentes, des budgets thermiques de fracture différents peuvent également être nécessaires.

Selon une possibilité de mise en oeuvre de l'invention, l'étape d'application du budget thermique de fracture comprend:
- une première étape comprenant l'application d'un premier budget thermique de sorte à transférer l'un des premier ou deuxième films minces sur le substrat souple; et
- une seconde étape comprenant l'application d'un deuxième budget thermique complémentaire de sorte à transférer l'autre des premier ou deuxième films minces sur le substrat souple.

Avantageusement, entre la première étape d'application du premier budget thermique et la seconde étape d'application du deuxième budget thermique complémentaire, le procédé comprend la mise en oeuvre d'au moins une opération de micro technologie ou de micro-électronique dans ou sur la face libre du premier ou du deuxième film mince transféré. La présence du support appelé aussi négatif qui n'est pas encore détaché de son film mince non transféré confère une certaine raideur à la structure. Cette raideur permet notamment d'appliquer des étapes qui peuvent être difficiles à réaliser sur une structure souple dont les deux films minces sont transférés, telles que des étapes de surfaçage ou de polissage.

Selon une possibilité, la mise en oeuvre d'au moins une opération de micro technologie ou de micro-électronique apporte au moins en partie le deuxième budget thermique complémentaire. Dans cette configuration, le deuxième budget thermique complémentaire peut être nettement réduit, ce qui permet de diminuer les temps de cycle et les coûts de fabrication.

Le procédé selon l'invention comprend typiquement la mise en oeuvre d'étapes de micro technologie ou de micro-électronique appliquées dans ou sur la face libre du premier et/ou du deuxième film mince transféré. Dans le cas où le transfert des films est obtenu en deux étapes entre lesquelles une étape technologique a été réalisée, ceci permet d'exécuter au moins une autre étape technologique sur le dernier film transféré. Dans le cas où les transferts des films minces sont obtenus en une seule étape, la structure résultante présente un rayon de courbure suffisant pour pouvoir fonctionnaliser l'un et/ou l'autre des films minces, ou y réaliser des procédés ou les utiliser dans les applications visées.

Selon une variante, le procédé comprend une étape qui consiste à sélectionner des matériaux présentant des modules d'Young différents pour former les films raidisseurs primaire et secondaire. Ceci permet de ne pas être limité par le choix d'un matériau de film raidisseur unique pour une même structure.

Selon une autre variante, les étapes d'implantations d'espèces ioniques dans les premier et deuxième substrats sources comprennent une étape d'implantation d'espèces ioniques avec des énergies différentes. De la sorte, il est possible d'obtenir des films minces d'une épaisseur différente de part et d'autre de la structure, notamment lorsque les films minces sont constitués d'un même matériau. Il est également possible d'obtenir des films minces d'une épaisseur différente par ce biais lorsque les matériaux des films minces sont différents.

De préférence, le premier et le deuxième film mince ont une épaisseur inférieure à 5 micromètres et de préférence inférieure à 2.5 micromètres de sorte à être adaptés aux applications souhaitées.

Selon la variante de réalisation dans laquelle la structure souple est dépourvue de films raidisseurs, les premier et deuxième films minces ont une épaisseur inférieure à 18 micromètres de sorte à présenter un effet raidisseur adapté pour transférer les films minces. Avantageusement, le procédé comprend une étape consistant à choisir une épaisseur différente pour les films raidisseurs primaire et secondaire de sorte à équilibrer les contraintes dans la structure selon la nature des matériaux des films minces, les épaisseurs de films minces et/ou les matériaux des films raidisseurs, et ce afin d'obtenir une structure finale de rayon de courbure élevée (soit sensiblement plane) en l'absence de sollicitation externe et à température ambiante.

Selon une possibilité, l'étape d'implantation consiste à implanter une ou plusieurs nature(s) d'espèces ioniques choisis parmi l'hydrogène, le bore, l'hélium ou d'autres gaz. Il est connu que la co-implantation (notamment d'hydrogène et d'hélium ou d'hydrogène et de bore) peut permettre de diminuer la température du budget thermique de fracture et éviter ainsi d'endommager le matériau du substrat souple, notamment lorsqu'il est constitué de polymère.

De préférence, les films raidisseurs primaire et secondaire présentent une épaisseur comprise entre 0.1 micromètre et 30 micromètres et de préférence entre 0.5 micromètre et 20 micromètres, et selon l'invention un module d'Young supérieur ou égal à 10 GPa, et comprennent de préférence un matériau en SiOxNy tel que le SiO₂, SiOx, SiON, SiN, Si₃N₄, SiN:H, le SixNy, ou en AlxOy tel que Al₂O₃ de sorte à ne pas trop rigidifier la structure souple finale.

Le SixNy est défini par la formule 0.2 < (y/x) < 1.4.

Selon une réalisation possible, le substrat souple est choisi parmi les feuilles métalliques, les polymères caoutchoutiques, les polymères vitreux tels que le Kapton®, de sorte à conférer la souplesse attendue à la structure souple.

Par exemple, les feuilles métalliques peuvent présenter une épaisseur comprise entre quelques micromètres et 50 micromètres, les polymères vitreux aux modules d'Young compris entre environ 10GPa et 100MPa peuvent présenter à titre d'exemple une épaisseur aux alentours de 50-200 micromètres. Les polymères caoutchoutiques aux modules d'Young compris entre 0.1 MPa et 20MPa peuvent présenter à titre d'exemple une épaisseur comprise entre 50 et 2000 micromètres.

De préférence, le matériau des premier et deuxième films minces est monocristallin et choisi par exemple parmi les matériaux piézoélectriques, les matériaux magnétiques, les matériaux semi-conducteurs, tels qu'un matériau comprenant des éléments de la colonne IV, tel que le Si, SiGe, ou un matériau comprenant des éléments des colonnes III et V, tel que le GaN, AlGaN, InGaN, AsGa ou InP par exemple. Il peut notamment s'agir d'un alliage binaire, ternaire ou quaternaire comprenant des éléments des colonnes III et V tels que le Ga, N, Al, In, P ou As.

Selon un mode de réalisation, les matériaux des premier et deuxième films minces peuvent être de même nature ou de nature différente.

Selon une possibilité, les premier et deuxième films minces peuvent être mono ou multi-matériaux.

Selon un deuxième aspect, l'invention concerne également une structure intermédiaire, cette structure comprenant de sa base vers sa surface :
- un des premier ou deuxième films minces, solidaire d'un négatif respectivement d'un premier ou d'un deuxième substrat source fragilisé,
- un des films raidisseurs primaire ou secondaire sur ledit premier ou deuxième film mince solidaire d'un négatif,
- un substrat souple dont la rigidité R est inférieure ou égale à 10⁷ GPa.µm³,
- un autre des films raidisseurs primaire ou secondaire, la rigidité cumulée des films raidisseurs primaire et secondaire étant inférieure ou égale à R,
- un autre des premier ou deuxième films minces, transféré sur le substrat souple, le film mince transféré présentant une épaisseur inférieure à 5 micromètres et avantageusement inférieure à 2.5 micromètres.
- les films raidisseurs primaire et secondaire présentant une épaisseur comprise entre 0.1 micromètre et 30 micromètres et de préférence entre 0.5 micromètre et 20 micromètres, un module d'Young supérieur ou égal à 10 GPa. Par le terme 'transférer' on entend dans le présent document l'action de fracturer un substrat source au niveau de la région de fragilisation obtenue par implantation d'espèces ioniques de sorte que le négatif du substrat source soit distinct du film mince, ce dernier ayant été rendu solidaire du substrat souple par le transfert.

Par l'expression 'film mince transféré' on entend dans le présent document, un film mince détaché ou désolidarisé d'un négatif d'un substrat source, au niveau d'une région de fragilisation obtenue par implantation d'espèces ioniques et qui a été solidarisé au substrat souple. La région de fragilisation est globalement plane et s'étend parallèlement à la surface du substrat source implanté.

Cette structure intermédiaire est préhensible, manipulable et souple du fait de la présence du substrat souple. Cette structure intermédiaire reste suffisamment raide pour supporter des étapes de surfaçage sur le film mince transféré.

Selon une variante de réalisation, la rigidité R du substrat souple est avantageusement inférieure à 7.10⁶ GPa.µm³.

Selon un troisième aspect, l'invention concerne une structure souple adaptée à la préhension, notamment pour l'application d'au moins une étape de micro-technologie, de microélectronique ou de nettoyage, obtenue à partir de la structure intermédiaire telle que décrite précédemment, cette structure comprenant de sa surface vers sa base :
- un premier film mince d'une épaisseur inférieure à 5 micromètres
- un film raidisseur primaire,
- un substrat souple dont la dont la rigidité R est inférieure ou égale à 10⁷ GPa.µm³,
- un film raidisseur secondaire,
- un deuxième film mince d'une épaisseur inférieure à 5 micromètres, la structure souple présentant un rayon de courbure supérieur à 20cm, de préférence supérieur à 50 cm et de préférence encore supérieur à 1 m en l'absence de sollicitation extérieure.
- les films raidisseurs primaire et secondaire présentant une épaisseur comprise entre 0.1 micromètre et 30 micromètres et de préférence entre 0.5 micromètre et 20 micromètres, un module d'Young supérieur ou égal à 10 GPa. Cette conformation assure à la structure souple d'être manipulable, tout en présentant une faible déformation spontanée. La structure souple peut avantageusement être déformée élastiquement selon les applications visées.

Selon un mode de réalisation particulier, la structure souple comprend des premier et deuxième films minces dans un matériau monocristallin choisi par exemple parmi les matériaux piézoélectriques, les matériaux magnétiques, les matériaux semi-conducteurs, tels qu'un matériau comprenant des éléments de la colonne IV, tel que le Si, SiGe, ou un matériau composé d'éléments des colonnes III etV, tels que le GaN, AlGaN, InGaN, AsGa ou InP, les films minces présentant une épaisseur comprise entre une dizaine de nanomètres et 5 micromètres,
- des films raidisseurs primaire et secondaire dans un matériau choisi parmi le SiOxNy tel que le SiO₂, SiOx, SiON, SiN, Si₃N₄, SiN:H, le SixNy, ou le AlxOy tel que Al₂O₃, et présentant une épaisseur comprise entre 0.1 micromètre et 30 micromètres et de préférence entre 0.5 micromètre et 20 micromètres,
- un substrat souple choisi parmi les feuilles métalliques, les polymères caoutchoutiques ou les polymères vitreux.
Le matériau des premiers et deuxièmes films minces peut notamment être un alliage binaire, ternaire ou quaternaire comprenant des éléments des colonnes III et V tels que le Ga, N, Al, In, P ou As.

De préférence, la structure souple comprend
- des premier et deuxième films minces comportant du silicium et présentant une épaisseur identique, comprise entre 0.01 micromètre et 2.5 micromètres, avantageusement entre 0.05 et 1.5 micromètres et plus avantageusement encore entre 0.1 à 1 micromètre,
- des films raidisseurs primaire et secondaire comportant de l'oxyde de silicium SiO2 et présentant une épaisseur identique, comprise entre 0.1 micromètre et 10 micromètres, avantageusement entre 2 et 6 micromètres,
- un substrat souple en polymère vitreux, tel que le Kapton®, présentant une épaisseur comprise entre 100 de 200 micromètres

D'autres aspects, buts et avantages de la présente invention apparaîtront mieux à la lecture de la description suivante de cinq modes de réalisation de celle-ci, donnée à titre d'exemples non limitatifs et faite en référence aux dessins annexés. Les figures ne respectent pas nécessairement l'échelle de tous les éléments représentés de sorte à améliorer leur lisibilité. Des traits pointillés symbolisent une première et une deuxième régions de fragilisation dans les substrats sources. La région de fragilisation est globalement plane et s'étend parallèlement à la surface du substrat source implanté. Dans la suite de la description, par souci de simplification, des éléments identiques, similaires ou équivalents des différentes formes de réalisation portent les mêmes références numériques.
Les figures 1A à 1E représentent des étapes d'un procédé de fabrication d'une structure souple selon un premier mode de réalisation de l'invention.
Les figures 2A à 2E représentent des étapes d'un procédé de fabrication d'une structure souple selon un deuxième mode de réalisation de l'invention.
Les figures 3A à 3F représentent des étapes d'un procédé de fabrication d'une structure souple selon un troisième mode de réalisation de l'invention.
Les figures 4A à 4E représentent des étapes d'un procédé de fabrication d'une structure souple selon un quatrième mode de réalisation de l'invention.
Les figures 5A à 5D représentent des étapes d'un procédé de fabrication d'une structure souple selon un cinquième mode de réalisation de l'invention.

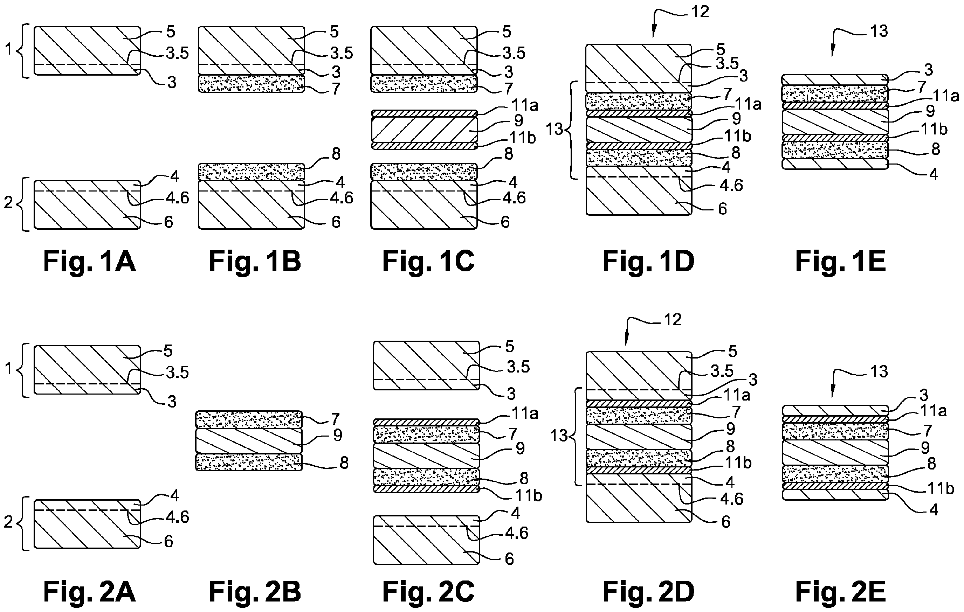

En référence à la figure 1A, le procédé est mis en oeuvre à partir de deux substrats sources 1,2 massifs en silicium monocristallin d'une épaisseur d'environ 725 micromètres. Les régions de fragilisation 3.5, 4.6 des premier et deuxième substrats sources 1,2 sont obtenues par implantation de deux natures d'espèces ioniques, le bore et l'hydrogène. Cette implantation, communément appelée co-implantation, est pratiquée dans les mêmes conditions dans les deux substrats sources 1,2. L'implantation est executée avec des doses de 10¹⁵ B/cm² et de 4.10¹⁶H/cm² avec des énergies respectives de 80keV et 27keV de sorte à délimiter les premier et deuxième films minces 3,4 et des premiers et deuxième négatifs 5 ,6 dans les substrats sources 1,2 respectifs. Cette co-implantation de bore et d'hydrogène est particulièrement efficace pour diminuer la température du budget thermique à appliquer pour le transfert de films minces de silicium. De la sorte, la température est avantageusement assez faible pour ne pas créér d'endommagement dans le substrat souple 1,2, notamment lorsque celui-ci comprend un polymère.

En référence à la figure 1B, des films raidisseurs primaire et secondaire 7,8 constitués de SiO2 sont déposés par une technique de dépôt en phase vapeur telle que la CVD (acronyme anglais de Chemical Vapor Deposition) respectivement sur les premier et deuxième films minces 3,4 jusqu'à atteindre une épaisseur de l'ordre de 3 micromètres. Les dépôts de ces films raidisseurs 7,8 sont effectués à une température de 250°C environ de sorte à ne pas fracturer les substrats sources 1,2. Néanmoins, cette étape de dépôt apporte tout de même un budget thermique préalable qui permet de réduire en durée ou en température le budget thermique de fracture ultérieur. Toute autre méthode de dépôt d'un film raidisseur 7,8 peut être utilisée dans la mesure où le budget thermique qui en résulte ne provoque pas la fracture.

En référence à la figure 1C, un substrat souple 9 constitué de polymère de type Kapton® d'une épaisseur de 125 micromètres est fourni pour une solidarisation avec les premier et deuxième films minces 3,4. Des première et deuxième couches d'un matériau adhésif 11a, 11b en DVS-bis-BCB sont déposées respectivement sur des première et deuxième faces du substrat souple 9 par enduction centrifuge ou dépôt à la tournette, méthode bien connue de l'homme de l'art sous la dénomination anglaise 'spin coating'. Alternativement, les première et deuxième couches d'un matériau adhésif 11a, 11b peuvent également être déposée sur les faces libres respectivement des films raidisseurs primaire et secondaire 7,8. L'épaisseur des couches d'un matériau adhésif 11a, 11b peut varier par exemple de 0.5 micromètre à plus de 10 micromètres.

En référence à la figure 1D, les premier et deuxième films minces 3,4, recouverts des films raidisseurs 7,8, sont ensuite mis en contact respectivement avec les première et deuxième faces du substrat souple 9. L'empilement 12 ainsi obtenu est placé dans un équipement de thermo-compression (non représenté) pour l'obtention d'un collage adhésif. Une pression de l'ordre de 10kPa à une température de 300°C est alors appliquée pendant environ 1 h45. La thermo-compression apporte également le budget thermique de fracture et induit la réticulation des couches d'un matériau adhésif 11a, 11b de DVS-bis-BCB.

En référence à la figure 1E, les films minces 3,4 d'une épaisseur d'environ 0.35 micromètre sont transférés sur le substrat souple 9 de Kapton® de sorte à former la structure souple 13. Le substrat 9 en polymère de 125 micromètres apporte une rigidité R inférieure ou égale à 1.5.10⁶ GPa.µm³. La rigidité de chacun des films raidisseurs 7,8 permet d'assurer le bon développement des cavités pour obtenir une fracture nette et sensiblement plane au niveau de la région fragilisée, qui ne serait pas obtenu avec le seul substrat souple 9. Cependant, l'épaisseur des films raidisseurs 7,8 de SiO2 est choisie de sorte à ce que la rigidité cumulée apportée par ces films reste inférieure ou égale à la rigidité R du substrat souple. Ceci permet de conférer la souplesse attendue à la structure souple 13 et aux films minces 3,4 monocristallins de silicium. La structure souple 13 obtenue peut en effet se déformer élastiquement sous l'action d'une contrainte extérieure, tout en restant préhensible et manipulable. Par ailleurs, la symétrie de la structure 13 permet d'équilibrer les contraintes générées au cours de la fabrication, liées par exemple aux conditions de dépôt des matériaux, de l'influence de la différence des CTE des matériaux lors des changements de température. Dans le cadre de l'invention, la structure 13 obtenue présente des contraintes sensiblement symétriques par rapport au substrat souple et de ce fait conserve un rayon de courbure très élevé ou une flèche très faible par exemple inférieure à 3 mm pour un diamètre de 200 mm. La structure souple 13 est donc manipulable et adaptée à la réalisation d'étapes de micro technologie ou de micro-électronique.

Selon une possibilité non illustrée, il est possible de réutiliser les négatifs 5,6 des substrats sources 1,2 et de le recycler pour un nouveau transfert.

Selon une variante non illustrée, il est également possible de procéder à un collage direct entre les films raidisseurs et le substrat souple si celui-ci le permet. Dans ce cas, les faces à assembler pourront subir, préalablement au collage, des préparations adéquates pour les rendre compatibles avec un tel collage, notamment en termes de rugosité et d'hydrophilie/d'hydrophobie.

Selon un deuxième mode de réalisation, en référence à la figure 2A, une co-implantation avec des doses de 10¹⁵ B/cm² et de 4.10¹⁶H/cm² et des énergies respectivement de 250keV et 70keV est effectuée de façon identique dans les deux substrats sources 1,2 de silicium. Les énergies d'implantation sont plus importantes que celles du premier mode de réalisation, ce qui correspond à des épaisseurs de films minces 3,4 également plus importantes.

En référence à la figure 2B, des films raidisseurs 7,8 de SiO2 sont déposés par CVD à une température de l'ordre de 250°C sur les première et deuxième faces d'un substrat souple 9 de type Kapton® identique à celui précédemment utilisé. Toute autre méthode de dépôt adaptée à la formation de films minces peut être utilisée dans la mesure où la température de dépôt n'excède pas une température qui pourrait endommager le substrat souple 9. Les épaisseurs de chacun des films raidisseurs 7,8 déposés sont identiques, elles peuvent varier entre 4 et 6 micromètres par exemple.

Selon une variante représentée à la figure 2C, des première et deuxième couches d'un matériau adhésif 11a, 11b sont déposées sur les faces exposées des films raidisseurs 7,8 puis sont mises en contact avec les substrats sources 1,2 fragilisés avant d'être réticulées. L'épaisseur de ces couches de matériau adhésif doit permettre une mise en compression oedométrique pour obtenir l'effet raidisseur pendant l'application du budget thermique pour la fracture. On pourra par exemple choisir une épaisseur de 0.1 micromètre. On pourra notamment se reporter à l'enseignement de la demande française déposée sous le numéro FR10/54969 dont le contenu doit être considéré comme faisant partie de la présente demande, pour mettre en oeuvre l'effet raidisseur nécessaire afin d'obtenir la fracture dans différents cas de figures.

En référence à la figure 2D, l'empilement 12 obtenu est embarqué dans un équipement de thermo-compression dans lequel une pression de l'ordre de 10kPa est appliquée à une température de 250°C pendant environ 14h pour atteindre le budget thermique de fracture.

En référence à la figure 2E, les films minces 3,4 d'une épaisseur d'environ 0.68 micromètre sont transférés sur le substrat souple 9 de Kapton® ce qui permet l'obtention d'une structure souple 13 dont le rayon de courbure spontané est supérieur à 1m. Cette structure souple 13 est manipulable, conformable et adaptée à la réalisation d'étapes de micro technologie ou de micro-électronique pour les mêmes raisons que celles explicitées ci-dessus.

La réticulation des couches d'un matériau adhésif 11a, 11b avant la mise en contact des surfaces à coller conduit à l'obtention d'une énergie de collage adhésif moins importante que lorsque la réticulation est effectuée après la mise en contact des surfaces. Ceci peut être avantageux si l'on souhaite démonter la structure souple 13 de sorte à isoler ou reporter des films minces sur d'autres substrats après fonctionnalisation par exemple.

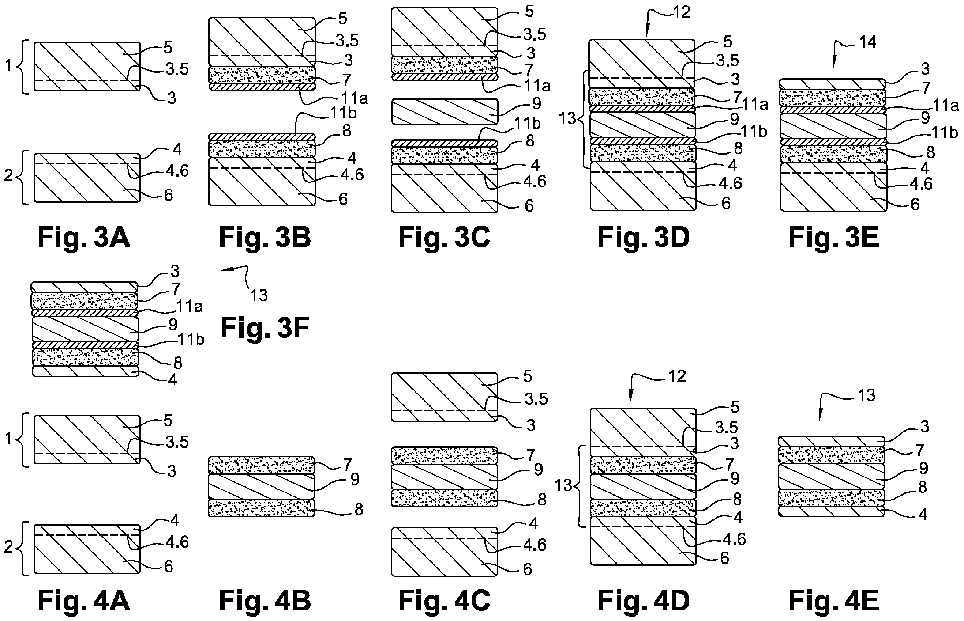

Selon un troisième mode de réalisation, en référence à la figure 3A, une co-implantation de bore et d'hydrogène est effectuée avec des doses différentes dans un premier substrat 1 et un deuxième substrat 2 de silicium. Des doses de 10¹⁵ B/cm² et de 4.10¹⁶H/cm² avec des énergies respectives de 80keV et 27keV sont implantées dans un premier substrat source 1. Le deuxième substrat source 2 reçoit des doses de 10¹⁵ B/cm² et de 3.10¹⁶H/cm² implantées avec des énergies respectives de 80keV et 27keV. Les doses implantées ayant une incidence directe sur le budget thermique de fracture, les deux films minces 3,4 peuvent alors être fracturés et transférés selon deux budgets thermiques différents.

En référence à la figure 3B, des films raidisseurs primaire et secondaire 7,8 de SiO2 sont déposés respectivement sur les premier et deuxième films minces 3,4 par CVD à une température d'environ 250°C. Des première et deuxième couches d'un matériau adhésif 11a, 11b, tel que le DVS-bis-BCB sont déposées sur les faces exposées des films raidisseurs 7,8.

En référence à la figure 3C, les deux substrats sources 1,2 fragilisés sont mis en contact avec un substrat souple 9 de type Kapton® avant réticulation du polymère DVS-bis-BCB.

En référence à la figure 3D, l'empilement 12 obtenu est placé dans un équipement de thermo-compression dans lequel un permier budget thermique est appliqué à une température de 300°C pendant environ 1 h45 avec une pression de l'ordre de 10kPa.

En référence à la figure 3E, le premier budget thermique conduit à l'obtention d'une structure intermédiaire 14 résultant du transfert d'un seul premier film mince 3 d'une épaisseur voisine de 0.35 micromètre. Il est alors possible d'appliquer par exemple des opérations de surfaçageou de polissage du premier film mince 3 monocristallin, ou d'autres étapes de microélectronique ou de microtechnologie plus faciles à appliquer sur la structure intermédiaire 14 encore solidaire du deuxième négatif 6 que sur la structure souple 13 finale.

En référence à la figure 3F, un deuxième budget thermique complémentaire est appliqué à la structure intermédiaire 14 à une température de 300°C pendant 18h. Il en résulte le transfert du deuxième film mince 4 d'une épaisseur voisine de 0.35 micromètre et la formation de la structure souple 13, manipulable et dont le rayon de courbure spontané est supérieur à 1 m.

Selon un quatrième mode de réalisation, en référence aux figures 4A à 4E, le procédé est mis en place en utilisant un collage direct entre les premiers et deuxième films minces 3,4 et les films raidisseurs primaire et secondaire 7,8.

En référence à la figure 4A, une co-implantation avec des doses de 10¹⁵ B/cm² et de 4.10¹⁶H/cm² et des énergies respectivement de 250keV et 70keV est effectuée de façon identique dans les deux substrats sources 1,2 de silicium.

En référence à la figure 4B, des films raidisseurs 7,8 de SiO2 sont déposés par CVD à une température de l'ordre de 250°C sur les première et deuxième faces d'un substrat souple 9 de type Kapton® identique à celui précédemment utilisé.

En référence à la figure 4C, les surfaces des films minces 3,4 et les surfaces des films raidisseurs 7,8 sont préparés pour un collage direct, notamment en termes de rugosité et d'hydrophilie/d'hydrophobie.

En référence à la figure 4D, les surfaces préparées sont mises en contact pour effectuer une solidarisation. Puis, un budget thermique de fracture est appliqué à l'empilement 12 obtenu à une température de 250°C pendant environ 14h.

En référence à la figure 4E, les films minces 3,4 d'une épaisseur d'environ 0.68 micromètre sont transférés sur le substrat souple 9 de Kapton® ce qui permet l'obtention d'une structure souple 13 dont le rayon de courbure spontané est supérieur à 1m. Cette structure souple 13 est manipulable, conformable et adaptée à la réalisation d'étapes de micro technologie ou de micro-électronique pour les mêmes raisons que celles explicitées ci-dessus.

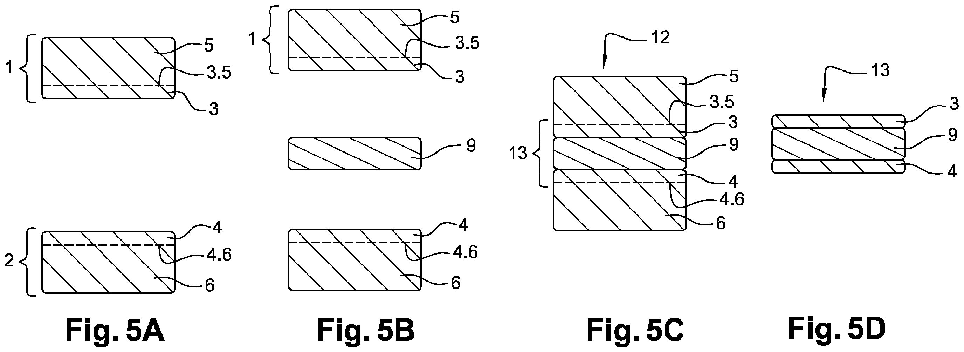

Selon un cinquième mode de réalisation, en référence aux figures 5A à 5D, la structure souple 13 fabriquée est dépourvue de films raidisseurs. L'effet raidisseur de la structure souple 13 adapté pour le transfert des films minces est alors obtenu en choisissant les matériaux du substrat souple et des films minces et en adaptant les épaisseurs de ces derniers en conséquence.

En référence à la figure 5A, le procédé est mis en oeuvre à partir de deux substrats sources 1,2 massifs en silicium monocristallin. Les régions de fragilisation 3.5, 4.6 des premier et deuxième substrats sources 1,2 sont réalisées à environ 15 microns de profondeur. On délimite ainsi des films minces 3,4 dont la rigidité est suffisante à elle-seule pour obtenir l'effet raidisseur nécessaire à la fracture. De tels films peuvent par exemple être obtenus en implantant de l'hydrogène avec des énergies supérieures à 500KeV (par exemple de l'ordre du MeV).

En référence à la figure 5B, un substrat souple 9 constitué d'une feuille métallique souple, d'une épaisseur par exemple de 15 microns, est fourni pour une solidarisation avec les premier et deuxième films minces 3,4. L'utilisation d'une feuille métallique présente l'avantage de résister à des températures plus élevées que la majorité des polymères de sorte qu'il est possible d'appliquer un budget thermique dont la température est supérieure.

En référence à la figure 5C, les premier et deuxième films minces 3,4, sont ensuite collés par collage direct respectivement avec les première et deuxième faces du substrat souple 9. L'empilement 12 est ensuite soumis à une température l'ordre de 450°C ou 500°C pour obtenir la fracture.

En référence à la figure 5D, les films minces 3,4 sont transférés sur le substrat souple 9 de sorte à former la structure souple 13. La rigidité de chacun des films minces 3,4 et du substrat souple 9 permet d'assurer le bon développement des cavités pour obtenir une fracture nette, sensiblement plane au niveau des régions fragilisées 3.5 4,6, qui ne serait pas obtenue avec le seul substrat souple 9. La structure souple 13 obtenue est sensiblement plane et peut se déformer élastiquement sous l'action d'une contrainte extérieure, tout en restant préhensible et manipulable.

Selon une variante non illustrée, la nature des matériaux des films raidisseurs primaires et secondaires peut être différente de part et d'autre du substrat souple. Les diverses contraintes (liées aux conditions de dépôt, aux différents coefficients de dilatation thermique des matériaux constituant la structure souple) et les divers modules de Young peuvent être pris en compte, pour facilement adapter, avec l'aide d'ouvrages classiques de mécanique si nécessaire, les épaisseurs des films raidisseurs de façon à obtenir une influence comparable de chaque coté du support souple. Ceci permet d'obtenir une structure souple finale sans ou avec peu de déformations dans le plan à température ambiante en l'absence de sollicitation extérieure. La structure engendrée est souple du fait du substrat souple et manipulable pour des opérations technologiques ultérieures. Selon un exemple non illustré, le procédé est mis en oeuvre à partir de deux substrats sources massifs en silicium monocristallin. Les plans de fragilisation des premier et deuxième substrats sources sont obtenus par co-implantation de bore et d'hydrogène avec des doses de 10¹⁵ B/cm² et de 4.10¹⁶H/cm² et des énergies respectivement de 250keV et 70keV.

Des films raidisseurs primaire et secondaire, constitués respectivement d'oxyde de silicium de SiO₂ et de nitrure de silicium SiₓN_{y}, sont déposés sur les premier et deuxième films minces avec une épaisseur respectivement de l'ordre de 7 micromètres et de l'ordre de 2 micromètres. Le nitrure de silicium SiₓN_{y} est généralement défini par la formule : 0.2 < (y/x) < 1.4.

Les dépôts de ces films raidisseurs sont effectués de telle sorte qu'ils ne présentent pas de contrainte sur les substrats sources à une température de 300 °C.

Un substrat souple constitué de polymère de type Kapton® d'une épaisseur de 125 micromètres est fourni pour une solidarisation avec les premier et deuxième films minces. Des première et deuxième couches d'un matériau adhésif en DVS-bis-BCB sont déposées respectivement sur chacun des films raidisseurs par enduction centrifuge ou dépôt à la tournette. Alternativement, les première et deuxième couches d'un matériau adhésif peuvent également être déposée sur au moins une des surfaces du substrat souple. L'épaisseur des couches d'un matériau adhésif peut varier par exemple de 0.1 micromètre à plus de 10 micromètres.

Les premier et deuxième films minces, recouverts des films raidisseurs primaire et secondaire, sont ensuite mis en contact respectivement avec les première et deuxième faces du substrat souple.

L'empilement est alors traité pour l'obtention d'un collage adhésif, par exemple en utilisant une pression de l'ordre de 10kPa à une température de 300°C appliquée pendant environ 1 h45.

Les films minces d'une épaisseur d'environ 0.65 µm sont transférés sur le substrat souple de Kapton® de sorte à former la structure souple, les films raidisseurs étant en position intermédiaire entre les films minces et le substrat souple.

La flèche de la structure souple obtenue est très faible, elle est inférieure par exemple à environ 5 mm pour un diamètre de structure souple de 200 mm.

Selon un autre exemple où tous les paramètres décrits ci-dessus ont été conservés à l'exception de l'épaisseur du film raidisseur primaire d'oxyde qui est plus faible, environ 6.75 µm, la flèche de la structure souple obtenue est de l'ordre de quelques centaines de micromètres.

Par ailleurs, les premier et deuxième substrats sources peuvent être implantés avec des énergies différentes. En particulier, les énergies d'implantation peuvent être plus ou moins élevées, ce qui correspond à la création des premier et deuxième films minces avec des épaisseurs différentes. Compte tenu des modules d'Young des matériaux utilisés, et de la différence d'épaisseur des films minces, il est possible de déduire la différence à appliquer pour l'épaisseur des films raidisseurs. Par exemple, le procédé est mis en oeuvre à partir de deux substrats sources massifs en silicium monocristallin. L'implantation dans le premier substrat source est réalisée par une co-implantation de 10¹⁵ B/cm² et de 4.10¹⁶H/cm², avec des énergies respectives de 250keV et 70keV. L'implantation dans le deuxieme substrat source est réalisée par une co-implantation de 10¹⁵ B/cm² et de 4.10¹⁶H/cm² et des énergies respectivement de 80keV et 27keV.

Des films raidisseurs primaire et secondaire sont déposés sur les premier et deuxième films minces, constitués respectivement d'oxyde de silicium de SiO₂ et de nitrure de silicium SiOₓN_{y}, avec une épaisseur respective de l'ordre de 6.5 µm et de l'ordre de 2 µm.

Des première et deuxième couches d'un matériau adhésif en DVS-bis-BCB sont déposées respectivement sur chacuns des films raidisseurs avant mise en contact respectivement avec les première et deuxième faces du substrat souple.

Une pression de l'ordre de 10kPa à une température de 300°C est alors appliquée à la structure pendant environ 1 h45.

Le premier film mince d'une épaisseur d'environ 0.65 µm et le deuxième film mince d'une épaisseur d'environ 0.35 µm sont transférés sur le substrat souple de Kapton® et forment la structure souple qui présente une flèche très faible. Elle est inférieure à environ 3 mm pour un diamètre de structure souple de 200 mm.

Selon une variante, une co-implantation de 10¹⁵ B/cm² et de 4.10¹⁶H/cm², avec des énergies respectives de 80keV et 27keV est réalisée dans le premier substrat source de silicium. Une co-implantation de 10¹⁵ B/cm² et de 4.10¹⁶H/cm² avec des énergies respectives de 250keV et 70keV est effectuée dans le deuxieme substrat source de silicium.

Dans cet exemple, un film raidisseur primaire d'oxyde de silicium de 7.25 µm d'épaisseur est déposé sur le premier film mince. Un film raidisseur secondaire de nitrure de silicium de 2 µm d'épaisseur est déposé sur le second film mince. Le support souple est de Kapton, d'épaisseur 125µm. Tous les autres paramètres précédemment décrits ont été conservés.

Le premier film mince transféré présente une épaisseur plus faible, environ 0.35 µm et le second film mince présente d'une épaisseur d'environ 0.65µm. La flèche de la structure souple obtenue est de l'ordre de quelques centaines de micromètres.

Selon le même principe, les matériaux des films minces monocristallins peuvent être différents de part et d'autre du substrat souple, et donc présenter une rigidité différente, ce qui peut induire des déformations différentes au niveau de la structure. En prenant en compte la différence des modules de Young des matériaux des films minces à reporter ainsi que leur différence de rigidité, il est possible de déduire la différence des épaisseurs des films raidisseurs à appliquer. Par exemple, si un matériau d'un premier film mince présente une rigidité inférieure à celle du matériau d'un deuxième film mince, l'épaisseur du film raidisseur primaire sera plus importante que celle du film raidisseur secondaire pour équilibrer les contraintes.

En variante non illustrée, il est également possible d'utiliser des première et deuxième couches d'un matériau adhésif de différentes natures de part et d'autre du substrat souple. Les adhésifs formés de polymères caoutchoutiques restent pratiquement sans incidence sur la rigidité de la structure souple. Par contre, ces adhésifs peuvent affecter la planéité de la structure, si les contraintes induites sur le substrat souple ne sont plus symétriques. L'homme du métier devra en tenir compte et faire le nécessaire en jouant notamment sur le choix des adhésifs et leur épaisseur pour conserver la symétrie.

Selon une autre variante non illustrée, les premier et deuxième substrats sources peuvent comporter une structure composite comprenant des films minces monocristallins de natures diverses, déposés par épitaxie sur un substrat support germe constitué d'un autre matériau.

Bien entendu, les dépôts des premier et deuxième films raidisseur peuvent être effectués en deux étapes successives. De la même façon, l'étape de solidarisation des deux films minces au substrat souple par collage direct ou via un film adhésif peuvent également être effectuées en deux étapes successives.

Selon une autre variante non illustrée, le procédé de l'invention peut également être mis en oeuvre par le dépôt du film raidisseur primaire sur le premier film mince et le dépôt du film raidisseur secondaire sur la deuxième face du substrat souple ou inversement.

Par ailleurs, la solidarisation du premier film mince sur la première face du substrat souple peut être mise en oeuvre par collage adhésif tandis que la solidarisation du deuxième film mince sur la deuxième face du substrat souple peut être exécutée par collage direct ou inversement.

Selon une variante non illustrée, une mono-implantation d'hydrogène à 25 KeV et avec une dose de 10¹⁷ H/cm² dans le silicium permet d'obtenir une fracture à 250°C en 15 heures. Selon encore une autre variante non illustrée, une co-implantation d'Hélium (60KeV, 4.10¹⁶ He/cm²) et d'hydrogène (32KeV, 4.10¹⁶ H/cm²) dans le silicium permet d'obtenir une fracture à 300°C en 20 heures. Ces conditions permettent d'obtenir des fractures avec un budget thermique faible, compatible avec le substrat souple, de la même façon que dans le cas d'une co-implantation d'hydrogène et de bore.

## Revendications

1. Procédé de fabrication d'une structure souple (13), ledit procédé comprenant les étapes suivantes :
- implanter des espèces ioniques dans un premier substrat source (1), de sorte à former une première région de fragilisation (3.5) délimitant un premier film mince (3), notamment constitué d'un matériau monocristallin,
- implanter des espèces ioniques dans un deuxième substrat source (2), de sorte à former une deuxième région de fragilisation (4.6) délimitant un deuxième film mince (4), notamment constitué d'un matériau monocristallin,
- fournir un substrat souple (9) dont la rigidité R est inférieure ou égale à 10⁷GPa.µm³,
- solidariser les premier et deuxième films minces (3,4) respectivement à la première face et à la deuxième face du substrat souple (9) de sorte à former un empilement (12) comportant la structure souple (13) délimitée par les première et deuxième régions de fragilisation (3.5, 4.6), la structure souple (13) présentant un effet raidisseur adapté pour permettre les transferts des premier et deuxième films minces (3,4), et
- appliquer un budget thermique de fracture pour transférer les premier et deuxième films minces (3,4) sur le substrat souple (9).

2. Procédé selon la revendication 1, **caractérisé en ce qu'**avant l'étape de solidarisation, le procédé comprend les étapes consistant à
- former au moins un film raidisseur primaire (7) sur le premier film mince (3) et/ou sur la première face du substrat souple (9), et
- former au moins un film raidisseur secondaire (8) sur le deuxième film mince (4) et/ou sur la deuxième face du substrat souple (9), la rigidité cumulée des films raidisseurs primaire et secondaire (7,8) étant inférieure ou égale à la rigidité R.

3. Procédé selon la revendication 2, **caractérisé en ce que** le procédé comprend les étapes de
- former le film raidisseur primaire (7) sur le premier film mince (3)
- former le film raidisseur secondaire (8) sur le deuxième film mince (4)
et **en ce que** l'étape de solidarisation comprend les étapes de
- former une première couche d'un matériau adhésif (11a), entre le film raidisseur primaire (7) et la première face du substrat souple (9), et
- former une deuxième couche d'un matériau adhésif (11b) entre le film raidisseur secondaire (8) et la deuxième face du substrat souple (9), le matériau adhésif est notamment choisi parmi le DVD-bis-BCB, les polyimides et les polymères photosensibles.

4. Procédé selon la revendication 2, **caractérisé en ce que** le procédé comprend les étapes de
- former le film raidisseur primaire (7) sur la première face du substrat souple (9),
- former le film raidisseur secondaire (8) sur la deuxième face du substrat souple (9),
et **en ce que** l'étape de solidarisation comprend un collage direct entre le film raidisseur primaire (7) et le premier film mince (3) et un collage direct entre le film raidisseur secondaire (8) et le deuxième film mince (4).

5. Procédé selon l'une des revendications 1 à 4, **caractérisé en ce que** les étapes d'implantation d'espèces ioniques dans les premier et deuxième substrats sources (1,2) comprennent une étape d'implantation de doses différentes d'espèces ioniques dans les premier et deuxième substrats sources (1,2).

6. Procédé selon l'une des revendications 1 à 5, **caractérisé en ce que** l'étape d'application du budget thermique de fracture comprend
- une première étape comprenant l'application d'un premier budget thermique de sorte à transférer l'un des premier ou deuxième films minces (3,4) sur le substrat souple (9) ; et
- une seconde étape comprenant l'application d'un deuxième budget thermique complémentaire de sorte à transférer l'autre des premier ou deuxième films minces (3,4) sur le substrat souple (9).

7. Procédé selon l'une des revendications 1 à 6, **caractérisé en ce que** le procédé comprend la mise en oeuvre d'au moins une étape de micro technologie ou de micro-électronique appliquée dans ou sur la face libre du premier et/ou du deuxième film mince (3, 4) transféré.

8. Procédé selon l'une des revendications 2 à 7, **caractérisé en ce que** le procédé comprend une étape consistant à choisir une épaisseur différente pour les films raidisseurs primaire et secondaire (7,8).

9. Procédé selon l'une des revendications 2 à 8, **caractérisé en ce que** les films raidisseurs primaire et secondaire (7,8) présentent une épaisseur comprise entre 0.1 micromètre et 30 micromètres et de préférence entre 0.5 micromètre et 20 micromètres, un module d'Young supérieur ou égale à 10 GPa, et comprennent de préférence un matériau en SiOxNy tel que le SiO₂, SiOx, SiON, SiN, Si₃N₄, SiN:H, le SixNy, ou en AlₓO_{y} tel que Al₂O₃.

10. Procédé selon l'une des revendications 1 à 9, **caractérisé en ce que** le substrat souple (9) est choisi parmi les feuilles métalliques, les polymères caoutchoutiques, les polymères vitreux tels que le Kapton®.

11. Procédé selon l'une des revendications 1 à 10, **caractérisé en ce que** le matériau des premier et deuxième films minces (3,4) est monocristallin et choisi par exemple parmi les matériaux piézoélectriques, les matériaux magnétiques, les matériaux semi-conducteurs tels qu'un matériau comprenant des éléments de la colonne IV, tel que le Si, SiGe, un matériau comprenant des éléments des colonnes III et V, tel quele GaN, AlGaN, InGaN, AsGa ou InP.

12. Structure intermédiaire (14) cette structure comprenant successivement de sa base vers sa surface:
- un des premier ou deuxième films minces (3,4), solidaire d'un négatif (5,6) respectivement d'un premier ou d'un deuxième substrat source (1,2) fragilisé,
- un des films raidisseurs primaire ou secondaire (7,8), sur ledit premier ou deuxième film mince (3,4) solidaire d'un négatif (5,6)
- un substrat souple (9) dont la rigidité R est inférieure ou égale à 10⁷GPa.µm³,
- un autre des films raidisseurs primaire ou secondaire (7,8), la rigidité cumulée des films raidisseurs primaire et secondaire (7,8) étant inférieure ou égale à R,
- un autre des premier ou deuxième films minces (3,4), transféré sur le substrat souple (9), le film mince (3,4) transféré présentant une épaisseur inférieure à 5 micromètres et avantageusement inférieure à 2.5 micromètres,
les films raidisseurs primaire et secondaire (7,8) présentant une épaisseur comprise entre 0.1 micromètre et 30 micromètres et de préférence entre 0.5 micromètre et 20 micromètres, un module d'Young supérieur ou égal à 10 GPa.

13. Structure souple (13) adaptée à la préhension, notamment pour l'application d'au moins une étape de micro-technologie, de microélectronique ou de nettoyage, cette structure comprenant successivement de sa surface vers sa base :
- un premier film mince (3) d'une épaisseur inférieure à 5 micromètres
- un film raidisseur primaire (7),
- un substrat souple (9) dont la rigidité R est inférieure ou égale à 10⁷GPa.µm³,
- un film raidisseur secondaire (8), la rigidité cumulée des films raidisseurs primaire et secondaire (7,8) étant inférieure ou égale à R,
- un deuxième film mince (4) d'une épaisseur inférieure à 5 micromètres, la structure souple (13) présentant un rayon de courbure supérieur à 20 cm, de préférence supérieur à 50 cm et de préférence encore supérieur à 1 m en l'absence de sollicitation extérieure,
les films raidisseurs primaire et secondaire (7,8) présentant une épaisseur comprise entre 0.1 micromètre et 30 micromètres et de préférence entre 0.5 micromètre et 20 micromètres, un module d'Young supérieur ou égal à 10 GPa.

14. Structure souple (13) selon la revendication 13, **caractérisé en ce que** les premier et deuxième films minces (3,4) comportent du silicium et présentent une épaisseur identique, comprise entre 0.01 micromètre et 2.5 micromètres, avantageusement entre 0.05 et 1.5 micromètres et plus avantageusement encore entre 0.1 et 1 micromètre,
les films raidisseurs primaire et secondaire (7,8) comportent de l'oxyde de silicium SiO2 et présentent une épaisseur identique, comprise entre 0.1 micromètre et 10 micromètres, et avantageusement entre 2 et 6 micromètres, et
le substrat souple (9) est en polymère vitreux, tel que le Kapton®, présentant une épaisseur comprise entre 100 de 200 micromètres.

## Patentansprüche

1. Verfahren zur Herstellung einer flexiblen Struktur (13), wobei das Verfahren die folgenden Schritte umfasst:
- Implantieren ionischer Spezies in ein erstes Quellensubstrat (1) derart, dass eine erste Schwächungsregion (3.5) gebildet wird, die einen ersten Dünnfilm (3) begrenzt, der insbesondere von einem monokristallinen Material gebildet ist,
- Implantieren ionischer Spezies in ein zweites Quellensubstrat (2) derart, dass eine zweite Schwächungsregion (4.6) gebildet wird, die einen zweiten Dünnfilm (4) begrenzt, der insbesondere von einem monokristallinen Material gebildet ist,
- Bereitstellen eines flexiblen Substrats (9), dessen Steifigkeit R unter oder gleich 10⁷ GPa.µm³ beträgt,
- festes Verbinden des ersten und zweiten Dünnfilms (3, 4) jeweils an der ersten Fläche und an der zweiten Fläche des flexiblen Substrats (9) derart, dass ein Stapel (12) gebildet wird, der die flexible Struktur (13) aufweist, die von der ersten und zweiten Schwächungsregion (3.5,4.6) begrenzt ist, wobei die flexible Struktur (13) eine Versteifungswirkung aufweist, die geeignet ist, um die Übertragungen des ersten und zweiten Dünnfilms (3, 4) zu erlauben, und
- Anwenden eines thermischen Frakturbudgets, um den ersten und zweiten Dünnfilm (3, 4) auf das flexible Substrat (9) zu übertragen.

2. Verfahren nach Anspruch 1, **dadurch gekennzeichnet, dass** das Verfahren vor dem Schritt des festen Verbindens die Schritte aufweist, die darin bestehen
- Ausbilden mindestens eines primären Versteifungsfilms (7) auf dem ersten Dünnfilm (3) und/oder auf der ersten Fläche des flexiblen Substrats (9), und
- Ausbilden mindestens eines sekundären Versteifungsfilms (8) auf dem zweiten Dünnfilm (4) und/oder auf der zweiten Fläche des flexiblen Substrats (9), wobei die kumulierte Steifigkeit des primären und sekundären Versteifungsfilms (7, 8) kleiner oder gleich der Steifigkeit R ist.

3. Verfahren nach Anspruch 2, **dadurch gekennzeichnet, dass** das Verfahren die Schritte
- Ausbilden des primären Versteifungsfilms (7) auf dem ersten Dünnfilm (3),
- Ausbilden des sekundären Versteifungsfilms (8) auf dem zweiten Dünnfilm (4)
umfasst und dadurch, dass der Schritt des festen Verbindens die Schritte
- Ausbilden einer ersten Schicht eines haftenden Materials (11a) zwischen dem primären Versteifungsfilm (7) und der ersten Fläche des flexiblen Substrats (9), und
- Ausbilden einer zweiten Schicht eines haftenden Materials (11b) zwischen dem sekundären Versteifungsfilm (8) und der zweiten Fläche des flexiblen Substrats (9) umfasst, wobei das haftende Materials insbesondere aus dem DVD-bis-BCB, den Polyimiden und den photosensiblen Polymeren ausgewählt ist.

4. Verfahren nach Anspruch 2, **dadurch gekennzeichnet, dass** das Verfahren die Schritte
- Ausbilden des primären Versteifungsfilms (7) auf der ersten Fläche des flexiblen Substrats (9),
- Ausbilden des sekundären Versteifungsfilms (8) auf der zweiten Fläche des flexiblen Substrats (9)
umfasst und dadurch, dass der Schritt des festen Verbindens ein direktes Kleben zwischen dem primären Versteifungsfilm (7) und dem ersten Dünnfilm (3) und ein direktes Verkleben zwischen dem sekundären Versteifungsfilm (8) und dem zweite Dünnfilm (4) umfasst.

5. Verfahren nach einem der Ansprüche 1 bis 4, **dadurch gekennzeichnet, dass** die Implantationsschritte ionischer Spezies in das erste und zweite Quellensubstrat (1, 2) einen Implantationsschritt unterschiedlicher Dosen ionischer Spezies in das erste und zweite Quellensubstrat (1, 2) umfassen.

6. Verfahren nach einem der Ansprüche 1 bis 5, **dadurch gekennzeichnet, dass** der Anwendungsschritt des thermischen Frakturbudgets umfasst
- einen ersten Schritt, umfassend die Anwendung eines ersten thermischen Budgets derart, dass einer von dem ersten oder zweiten Dünnfilm (3, 4) auf das flexible Substrat (9) übertragen wird; und
- einen zweiten Schritt, umfassend die Anwendung eines komplementären zweiten thermischen Budgets derart, dass der andere von dem ersten oder zweiten Dünnfilm (3, 4) auf das flexible Substrat (9) übertragen wird.

7. Verfahren nach einem der Ansprüche 1 bis 6, **dadurch gekennzeichnet, dass** das Verfahren die Umsetzung mindestens eines mikrotechnologischen oder mikroelektronischen Schritts umfasst, angewendet in oder auf der freien Fläche des übertragenen ersten und/oder zweiten Dünnfilms (3, 4).

8. Verfahren nach einem der Ansprüche 2 bis 7, **dadurch gekennzeichnet, dass** das Verfahren einen Schritt umfasst, der darin besteht, eine unterschiedliche Stärke für den primären und sekundären Versteifungsfilm (7, 8) auszuwählen.

9. Verfahren nach einem der Ansprüche 2 bis 8, **dadurch gekennzeichnet, dass** der primäre und sekundäre Versteifungsfilm (7, 8) eine Stärke inklusive zwischen 0,1 Mikrometer und 30 Mikrometer und vorzugsweise zwischen 0,5 Mikrometer und 20 Mikrometer, ein Young-Modul über oder gleich 10 GPa aufweisen und vorzugsweise ein Material aus SiOxNy wie das SiO₂, SiOx, SiON, SiN, Si₃N₄, SiN:H, das SixNy, oder aus AlxOy wie Al₂O₃ umfassen.

10. Verfahren nach einem der Ansprüche 1 bis 9, **dadurch gekennzeichnet, dass** das flexible Substrat (9) aus den Metallfolien, den Kautschukpolymeren, den glasartigen Polymeren wie das Kapton® ausgewählt ist.

11. Verfahren nach einem der Ansprüche 1 bis 10, **dadurch gekennzeichnet, dass** das Material des ersten und zweiten Dünnfilms (3, 4) monokristallin ist und beispielsweise aus den piezoelektrischen Materialien, den magnetischen Materialien, den Halbleitermaterialien wie ein Material, das Elemente der Spalte IV wie das Si, SiGe umfasst, ein Material, das Elemente der Spalten III und V wie das GaN, AlGaN, InGaN, AsGa oder InP umfasst, ausgewählt ist.

12. Übergangsstruktur (14), wobei diese Struktur aufeinanderfolgend von ihrer Basis zu ihrer Oberfläche umfasst:
- einen von dem ersten oder zweiten Dünnfilm (3, 4), fest verbunden mit einem Negativ (5, 6) jeweils eines ersten oder eines zweiten geschwächten Quellensubstrats (1, 2),
- einen von dem primären oder sekundären Versteifungsfilm (7, 8) auf dem ersten oder zweiten Dünnfilm (3, 4), fest verbunden mit einem Negativ (5, 6),
- ein flexibles Substrat (9), dessen Steifigkeit R unter oder gleich 10⁷ GPa.µm³ beträgt,
- einen anderen von dem primären oder sekundären Versteifungsfilm (7, 8), wobei die kumulierte Steifigkeit des primären und sekundären Versteifungsfilms (7, 8) unter oder gleich R beträgt,
- einen anderen von dem ersten oder zweiten Dünnfilm (3, 4), übertragen auf das flexible Substrat (9), wobei der übertragene Dünnfilm (3, 4) eine Stärke von weniger als 5 Mikrometer und vorzugsweise weniger als 2,5 Mikrometer aufweist,
wobei der primäre und sekundäre Versteifungsfilm (7, 8) eine Stärke zwischen inklusive 0,1 Mikrometer und 30 Mikrometer und vorzugsweise zwischen 0,5 Mikrometer und 20 Mikrometer, ein Young-Modul über oder gleich 10 GPa aufweisen.

13. Flexible Struktur (13), geeignet für das Festhalten, insbesondere für das Anwenden mindestens eines mikrotechnologischen, mikroelektronischen oder Reinigungsschritts, wobei diese Struktur aufeinanderfolgend von ihrer Oberfläche zu ihrer Basis umfasst:
- einen ersten Dünnfilm (3) einer Stärke unter 5 Mikrometer,
- einen primären Versteifungsfilm (7),
- ein flexibles Substrat (9), dessen Steifigkeit R unter oder gleich 10⁷ GPa.µm³ beträgt,
- einen sekundären Versteifungsfilm (8), wobei die kumulierte Steifigkeit des primären und sekundären Versteifungsfilms (7, 8) unter oder gleich R beträgt,
- einen zweiten Dünnfilm (4) einer Stärke unter 5 Mikrometer, wobei die flexible Struktur (13) einen Krümmungsradius über 20 cm, vorzugsweise über 50 cm und noch vorzugsweiser über 1 m bei Abwesenheit äußerer Beanspruchung aufweist,
wobei der primäre und sekundäre Versteifungsfilm (7, 8) eine Stärke zwischen inklusive 0,1 Mikrometer und 30 Mikrometer und vorzugsweise zwischen 0,5 Mikrometer und 20 Mikrometer, ein Young-Modul über oder gleich 10 GPa aufweisen.

14. Flexible Struktur (13) nach Anspruch 13, **dadurch gekennzeichnet, dass** der erste und zweite Dünnfilm (3, 4) Silizium aufweisen und eine identische Stärke inklusive zwischen 0,01 Mikrometer und 2,5 Mikrometer, vorzugsweise zwischen 0,05 und 1,5 Mikrometer und noch vorzugsweiser zwischen 0,1 und 1 Mikrometer aufweisen,
der primäre und sekundäre Versteifungsfilm (7, 8) Siliziumoxid SiO2 aufweisen und eine identische Stärke inklusive zwischen 0,1 Mikrometer und 10 Mikrometer und vorzugsweise zwischen 2 und 6 Mikrometer aufweisen, und
das flexible Substrat (9) ein glasartiges Polymer wie das Kapton® ist, aufweisend eine Stärke inklusive zwischen 100 und 200 Mikrometer.

## Claims

1. A method for manufacturing a flexible structure (13), the method comprising the following steps:
- implanting ionic species in a first source substrate (1) so as to form a first embrittlement region (3.5) delimiting a first thin film (3) notably consisting of a single-crystal material,
- implanting ionic species in a second source substrate (2) so as to form a second embrittlement region (4.6) delimiting a second thin film (4), notably consisting of a single-crystal material,
- providing a flexible substrate (9), the stiffness R of which is less than or equal to 10⁷GPa.µm³,
- securing the first and second thin films (3, 4) respectively to the first face and to the second face of the flexible substrate (9) so as to form a stack (12) including the flexible structure (13) delimited by the first and second embrittlement regions (3.5, 4.6), the flexible structure (13) having a stiffening effect suitable for allowing transfers of the first and second thin films (3, 4), and
- applying a fracture thermal budget for transferring the first and second thin films (3, 4) onto the flexible substrate (9).

2. The method according to claim 1, **characterized in that** before the securing step, the method comprises the steps:
- forming at least one primary stiffening film (7) on the first thin film (3) and/or on the first face of the flexible substrate (9), and
- forming at least one secondary stiffening film (8) on the second thin film (4) and/or on the second face of the flexible substrate (9), the cumulated stiffness of the primary and secondary stiffening films (7, 8) being less than or equal to the stiffness R.

3. The method according to claim 2, **characterized in that** the method comprises the steps :
- forming the primary stiffening film (7) on the first thin film (3)
- forming the secondary stiffening film (8) on the second thin film(4) and **in that** the securing step comprises the steps:
- forming a first layer of an adhesive material (11a), between the primary stiffening film (7) and the first face of the flexible substrate (9), and
- forming a second layer of an adhesive material (11b) between the secondary stiffening film (8) and the second face of the flexible substrate (9), the adhesive material is notably selected from DVD-bis-BCB, polyimides and photosensitive polymers.

4. The method according to claim 2, **characterized in that** the method comprises the steps:
- forming the primary stiffening film (7) on the first face of the flexible substrate (9),
- forming the secondary stiffening film (8) on the second face of the flexible substrate (9),
and **in that** the securing step comprises direct bonding between the primary stiffening film (7) and the first thin film (3) and direct bonding between the secondary stiffening film (8) and the second thin film (4).

5. The method according to one of claims 1 to 4, **characterized in that** the steps for implanting ionic species into the first and second source substrates (1, 2) comprise a step for implanting different doses of ionic species into the first and second source substrates (1, 2).

6. The method according to one of claims 1 to 5, **characterized in that** the step for applying the fracture thermal budget comprises:
- a first step comprising the application of a first thermal budget so as to transfer one of the first or second thin films (3, 4) onto the flexible substrate (9); and
- a second step comprising the application of a second additional thermal budget so as to transfer the other one of the first and second thin films (3, 4) onto the flexible substrate (9).

7. The method according to one of claims 1 to 6, **characterized in that** the method comprises the application of at least one microtechnology or microelectronics step applied in or on the free face of the first and/or the second transferred thin film (3, 4).

8. The method according to one of claims 2 to 7, **characterized in that** the method comprises a step consisting of selecting a different thickness for the primary and secondary stiffening films (7, 8).

9. The method according to one of claims 2 to 8, **characterized in that** the primary and secondary stiffening films (7, 8) have a thickness comprised between 0.1 micrometers and 30 micrometers and preferably between 0.5 micrometers and 20 micrometers, a Young's modulus greater than or equal to 10 GPa, and preferably comprise a material in SiOₓN_{y} such as SiO₂, SiOₓ, SiON, SiN, Si₃N₄, SiN:H, SiₓN_{y}, or in AlxOy such as Al₂O₃.

10. The method according to one of claims 1 to 9, **characterized in that** the flexible substrate (9) is selected from metal sheets, rubber polymers, glassy polymers such as Kapton®.

11. The method according to one of claims 1 to 10, **characterized in that** the material of the first and second thin films (3, 4) is a single-crystal material and for example selected from piezoelectric materials, magnetic materials, semiconducting materials such as a material comprising elements from column IV such as Si, SiGe, a material comprising elements from columns III and IV, such as GaN, AlGaN, InGaN, AsGa or InP.

12. An intermediate structure (14) this structure comprising successively from its base to its surface:
- one of the first or second thin films (3, 4) secured to a negative (5, 6) of a first or second embrittled source substrate (1, 2) respectively,
- one of the primary or secondary stiffening films (7, 8) on said first or second thin film (3, 4) secured to a negative (5, 6)
- a flexible substrate (9), the stiffness R of which is less than or equal to 10⁷GPa.µm³,
- another of the primary or secondary stiffening films (7, 8), the cumulated stiffness of the primary and secondary stiffening films (7, 8) being less than or equal to R,
- another of the first or second thin films (3, 4), transferred onto the flexible substrate (9), the transferred thin film (3, 4) having a thickness of less than 5 micrometers and advantageously less than 2.5 micrometers; the primary and secondary stiffening films (7,8) having a thickness comprised between 0,1 micrometer and 30 micrometers and preferably between 0,5 micrometer and 20 micrometers and a Young's modulus greater than or equal to 10 GPa.

13. A flexible structure (13) suitable for being grasped, notably for applying at least one microtechnology, microelectronics or cleaning step, this structure comprising successively from its surface to its base:
- a first thin film (3) with a thickness of less than 5 micrometers,
- a primary stiffening film (7),
- a flexible substrate (9), the stiffness R of which is less than or equal to 10⁷GPa.µm³,
- a secondary stiffening film (8), the cumulated stiffness of the primary and secondary stiffening films (7, 8) being less than or equal to R,
- a second thin film (4) with a thickness of less than 5 micrometers, the flexible structure (13) having a radius of curvature greater than 20 cm, preferably greater than 50 cm and still preferably greater than 1 m in the absence of external stress,
the primary and secondary stiffening films (7,8) having a thickness comprised between 0,1 micrometer and 30 micrometers and preferably between 0,5 micrometer and 20 micrometers and a Young's modulus greater than or equal to 10 GPa.

14. The flexible structure (13) according to claim 13, **characterized in that** the first and second thin films (3, 4) include silicon and have identical thickness, comprised between 0.01 micrometers, and 2.5 micrometers, advantageously between 0.05 and 1.5 micrometers and still more advantageously between 0.1 and 1 micrometer,
the primary and secondary stiffening films (7, 8) include silicon oxide SiO₂ and have identical thickness, comprised between 0.1 micrometers and 10 micrometers, and advantageously between 2 and 6 micrometers, and
the flexible substrate (9) is in a glassy polymer, such as Kapton®, having a thickness comprised between 100 and 200 micrometers.
